Europäisches Patentamt

European Patent Office

Office européen des brevets

(11) Publication number: **0 243 182**
**A2**

## (12) EUROPEAN PATENT APPLICATION

(21) Application number: **87303568.7**

(22) Date of filing: **23.04.87**

(51) Int. Cl.³: **H 01 F 7/08**
**G 05 D 7/06**

(30) Priority: **25.04.86 GB 8610205**

(43) Date of publication of application:
**28.10.87 Bulletin 87/44**

(84) Designated Contracting States:
**DE FR GB IT SE**

(71) Applicant: **Dowty Hydraulic Units Ltd.**
**Arle Court**
**Cheltenham Gloucestershire GL51 OTP(GB)**

(72) Inventor: **Grainger, John Richard**
**55, Pinewood Road**
**Quedgeley Gloucester Gloucestershire(GB)**

(74) Representative: **Bousfield, Roger James**
**Patents Department Dowty Group Services Limited Arle**
**Court**
**Cheltenham, Glos. GL51 0TP(GB)**

(54) **An induction coil.**

(57) An induction coil for use with a control device comprises a series of independent windings (12, 13, 14) about a common axis (x — x) having a first winding (12) which produces an output signal and a second winding which produces a second output signal greater in strength than the output signal of the first winding.

The difference in output signal of the windings (12, 14) may be achieved by either varying the number of turns of conductive material on the winding or varying the input signal to the windings. A combination of there alternatives may also be used.

The induction coil may then be used in a control device which in turn may form part of a control system.

Fig.1

# "AN INDUCTION COIL"

This invention relates to an induction coil and in particular to an induction coil for use in a digital control system.

A known control system uses a digital signal to control the output from a control device such as a servo-valve. It is necessary, however, in known control systems to convert a digital control signal into an analogue control signal for supply to an analogue control device for this function.

It is a disadvantage with known devices that digital to analogue converters are inaccurate or expensive if accuracy is to be built into the system.

The present invention is concerned with providing a relatively inexpensive control device for use with control devices such as servo-valves.

According to the present invention an induction coil for use with a control device comprises independent windings arranged in a series about a common axis wherein a first winding which produces an output signal and a second winding which produces a second output signal of greater strength than that of the first winding.

Preferably, the difference in output signal is produced by providing the first winding with a lesser number of turns than the second winding. Whereupon when the input signal to each winding is of identical strength the output signals therefrom will be of different strengths.

The induction coil may be formed with any number of windings in excess of two.

The windings will, preferably, be arranged in a series with the first winding in the series being the said first winding and the last winding in the series being the said second winding. Preferably, each winding of the series will have a greater number of turns than the previous winding in the series.

In a preferred embodiment, the number of turns on each winding in the series is such that exclusive energisation of successive ascending windings in the series will produce a doubling of the magnetomotive force produced by the exclusive energisation of the preceding winding.

The windings of the induction coil are preferably arranged so as to produce a variable magnetomotive force. In such a case the magnetomotive force can be varied between zero when no windings are energised and a maximum when all of the windings are energised. Further the windings may be energised by discrete energising combinations dependent upon the level of magnetomotive force required.

Preferably, the variation of the magnetomotive force of the induction coil is in incremental steps. The level of each step preferably being equal in strength to the level of the magnetomotive force produced by energising the first winding. In this case the magnetomotive force of the respective winding in the series will be $2^{(n-1)}$ x the magnetomotive force of the first winding, where n equal the number of the winding in the series.

In a preferred embodiment the windings are arranged concentrically of one another.

Alternatively, the windings may be arranged in a line or as a series of groups of concentrically arranged windings in a line.

Alternatively, each of the windings may be provided with an identical number of turns of electrically conductive material for example copper wire and the first winding has an input signal which is of lesser strength than the input to the second winding.

Further, the difference in the output signal from the windings may be achieved by a combination of altering the number of turns of the winding and the input signal to the winding.

The input to or the number of turns of the winding may be adjusted/varied to take account of any nonlinearity in the control valve.

The invention also includes a control device incorporating an induction coil in accordance with the present invention.

The control device is preferably a servo-valve, and most preferably a flapper-nozzle valve having a force motor which includes at least two of the induction coils in accordance with the present invention.

The control device alternatively may be a solenoid valve having at least one induction coil in accordance with the present invention.

A winding which is used in a control device is made so that the number of turns of each of the windings may be adapted so as to produce a linear output from the control device.

The present invention also includes a digital control system having a digital control unit with a control device in accordance with the present invention, wherein the output from a section of the digital control unit is connected to the first of the windings and the output of the other sections of the control unit are sequentially connected to the remaining windings in the series. The digital control unit may include mechanically operable binary switches or alternatively a digital computer means.

The invention will now be described by way of example with reference to the accompanying drawings in which:-

Fig 1   shows a schematic diagram of first induction coil according to the present invention;

Fig 2    shows a schematic diagram of second
          induction coil according to the present
          invention;

Fig 3    shows a diagrammatic representation of a
          first control unit in accordance with the
          present invention, and

Fig 4    shows a diagrammatic representation of a
          second control unit in accordance with the
          invention.

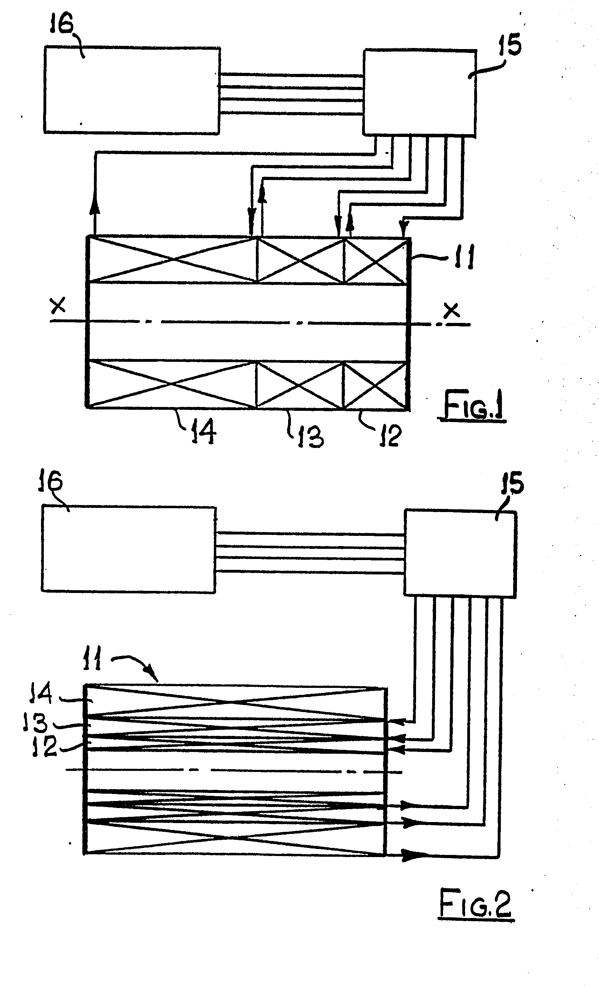

Now referring to Fig 1 of the drawings an
induction coil 11 comprises a series of
independent windings 12,13,14 arranged in a line
about a common axis X - X; a source of power 15,
and a digital control unit 16.

The windings are arranged so that the number of
turns of electrically conductive material, of the
windings is such that the first winding 12 has the
least number of turns, and a last winding 14 has
the greatest number of turns with the winding 13
having a number of turns intermediate of the other
two.

The number of turns of each winding is such that exclusive energisation of the last winding 14 by the source of power 15 will produce a magnetomotive force that is twice the level of the force produced by energising the intermediate winding 13 and four times that produced by energising the first winding 12.

The magnetomotive force produced by the induction coil 11 for a unit of energising current is varied in response to a control signal from the digital control unit 16 between zero when none of the windings 12, 13, 14 are energised and a maximum when all of the windings 12, 13, 14 are energised in incremental steps. Each incremental step is substantially equal to the magnetomotive force produced by energising the first winding 12 only.

With reference to Fig 2 there is shown a second induction coil which is similar to that described with reference to Fig 1, except that in this case the windings of the induction coil are arranged concentrically. The first winding 12 being the inner most, winding 14 being the outer most and winding 13 is intermediate of these two windings.

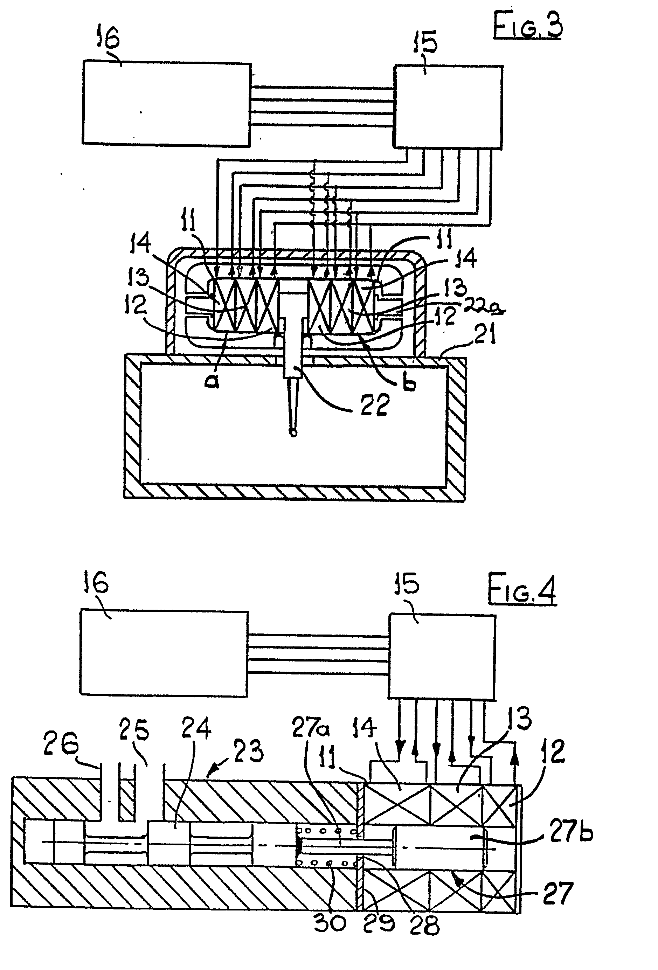

Now referring to Fig 3 a digital control system comprises two induction coil 11 as described with reference to Fig 1 a digital control unit 16, a source of power 15, for example a power amplifier means and a flapper-nozzle servo-valve 21.

The servo-valve 21 maybe of any conventional construction having a mechanical feedback cantilver 22 with an armature 22a extending therethrough and therefore no detailed description will be given.  The only difference is the inclusion of the two induction coils 11 in relation to the armature of the cantilver 22.

The cantilver 22 is mounted so that the end 22a thereof is positioned intermediate of the two distinct groups of windings A, B.  The windings being arranged so that the two first windings 12 of each group are closest to the cantilever 22 and the second windings 14 of each group are furthest therefrom.

The fluid output from the servo-valve is controlled by the digital control unit 16 which sends a binary signal to the power amplifier means 15.  The binary signal may comprise a four bit binary word in which case three of the bits of the binary word are used to activate or deactivate a separate amplifier (not shown) and the fourth bit is used to change the polarity of the output from respective amplifiers of the power amplifier means 15. As an example of the operation binary words of numeric value less than eight can be arranged to produce a negative output from the respective amplifiers and binary words of numeric value greater than or equal to eight a positive output therefrom.

The output from each respective amplifier is supplied to the respective winding 12, 13, 14 so that it is possible to energise individually each winding or energise any combination of the windings 12, 13, 14, depending upon the value of the binary word sent to the power amplifier means 15.

With reference to Fig 4 a second digital control system is similar to that described with reference to Fig 3 and comprises an induction coil 11 as described in Fig 1; a digital control unit 16; a source of power 15, and a solenoid valve control device 23.

The solenoid valve 23, has a spool 24 movable in a casing by the induction coil 11 to control the flow of fluid passing from an inlet port 25 to an outlet port 26.

The solenoid value is arranged so that the windings 12, 13, 14 are mounted with the second winding 14 abutting against a wall 29 which divides the spool 23 from the windings with the first winding being furthest from this wall 29 and the second winding closest thereto.

The spool 23 is moved within the casing by the action of an armature 27 having a body member 27a and a rod section 27b which abuts an end 23a of the spool.

The rod section 27b of armature 27 passes through an aperature 28 in the wall 29 so that body member 27a is housed within the windings. The armature 27 is moved along the longitudinal axis about which the windings are wound.

A spring 30 is also provided which acts between the wall 29 and the end 23a of the spool to ensure that when the windings are deactivated the spool is returned to a position in which the outlet port 25 is closed.

The flow from the solenoid valve 23 is controlled by the digital control unit 16 which sends a binary word to the power source means 15 as previously described (with reference to Fig 3). The solenoid valve 23 is therefore directly controlled by digital signals sent from the digital control unit 16.

**0243182**

CLAIMS

1. An induction coil for use with a control device comprises independent windings arranged in series about a common axis wherein a first winding (12) produces an output signal and a second winding (14) produces a second output signal of greater strength than that of the first winding.

2. An induction coil as claimed in claim 1, wherein the difference in output signal is produced by providing the first winding with a lesser number of turns than the second winding.

3. An induction coil as claimed in claim 1 or claim 2, wherein the windings are arranged in a series with the first winding in the series being the said first winding and the last winding in the series being the said second winding.

4. An induction coil as claimed in any one of the preceding claims, wherein each winding of the series has a greater number of turns than the previous winding in the series.

5. An induction coil as claimed in anyone of the preceding claims, wherein the number of turns on each winding in the series is such that exclusive energisation of successive ascending windings in the series will produce a doubling of the magnetomotive force produced by the exclusive energisation of the preceding winding.

6. An induction coil as claimed in anyone of the preceding claims, wherein the windings of the induction coil are preferably arranged so as to produce a variable magnetomotive force.

7. An induction coil as claimed in anyone of the preceding claims, wherein the variation of the magnetomotive force produced by the induction coil is in incremented steps each of which steps is equal in strength to the level of the magnetomotive force produced by energising the said first winding.

8. An induction coil as claimed in claim 1 or claim 3 or anyone of claims 5 to 7 wherein each of the windings may be provided with an identical number of turns of electrically conductive material for example copper wire and the first winding has an input signal which is of lesser strength than the input to the second winding.

9. A control device which includes an induction coil as claimed in anyone of the preceding claims.

wherein the control device is a flapper nozzle servo valve.

10  A digital control system having a digital control unit with a control device as claimed in claim 9 wherein the output from a section of the digital control unit is connected to the first of the windings and the output of the other sections of the control unit are sequentially connected to the remaining windings in the series.

1/2

Fig.1

Fig.2

Fig.3

Fig.4